# EUROPEAN PATENT APPLICATION

(11) **EP 4 556 598 A1**
(43) Date of publication of application: **21.05.2025**
(21) Application number: 23839838.2
(22) Date of filing: 26.06.2023
(51) Int. Cl.: C25D 1/00, C25D 1/04, C25D 1/10

(54) **METAL FOIL CONTINUOUS PLATING APPARATUS, METAL FOIL CONTINUOUS PLATING METHOD, AND METHOD FOR MANAGING ELECTROLYTE SOLUTION OF CONTINUOUS PLATING APPARATUS**

(30) Priority: 13.07.2022 KR 20220086252; 25.01.2023 KR 20230009321
(71) Applicant: Industry-Academic Cooperation Foundation of Sunchon National University, Suncheon-si, Jeollanam-do 57922 (KR)
(72) Inventor: PARK, Yong Bum, Goyang-si Gyeonggi-do 10501 (KR); KIM, In Gyeong, Suncheon-si Jeollanam-do 57905 (KR)
(74) Representative: Beck & Rössig European Patent Attorneys
(86) International application number: PCT/KR2023/008816
(87) International publication number: WO 2024/014744

(57) **Abstract**

The present invention relates to a manufacturing apparatus and a manufacturing method therefor, which are capable of manufacturing, with high quality, a metal foil such as an iron-nickel alloy foil, a nickel foil and a copper foil through a continuous plating method.

A metal foil continuous plating apparatus according to the present invention includes an electrolytic bath for accommodating an electrolyte solution, a positive electrode arranged inside the electrolytic bath, a negative electrode arranged at a predetermined interval from the positive electrode so as to face the positive electrode, and a power supply device for applying a current to the positive electrode and the negative electrode, wherein the electrolyte solution is supplied to one side of a space formed between the positive electrode and the negative electrode, and the electrolyte solution is discharged from the other side of the space, wherein the height of the one side to which the electrolyte solution is supplied is formed higher than that of the other side so that the electrolyte solution flows through the space formed between the positive electrode and the negative electrode by means of a difference in potential energy between the one side and the other side, and passes through the space formed between the positive electrode and the negative electrode, during which metal ions contained in the electrolyte solution are electro-deposited on the negative electrode, thereby forming a metal foil.

## Description

### TECHNICAL FIELD

The present invention relates to a metal foil continuous plating apparatus, a metal foil continuous plating method, and a method for managing an electrolyte solution of a continuous plating apparatus, and more particularly, to a continuous plating apparatus capable of manufacturing, with high quality, a metal foil such as an iron-nickel alloy foil, a nickel foil, and a copper foil through a continuous plating method, a continuous plating method, and a method for managing an electrolyte solution of a continuous plating apparatus.

### BACKGROUND ART

An Invar alloy is an alloy having a very low thermal expansion coefficient, and is a material used in various fields such as a precision meter, a bimetal, a shadow mask, a lead frame of an integrated circuit, a display encapsulant, and a metal mask of an organic light-emitting diode.

In order to increase the resolution of an OLED applied to a smartphone, the thickness of a fine metal mask (FMM) used in a deposition process is required to be reduced.

Such a fine metal mask is manufactured by a top-down method through casting-rolling-etching, but since it is difficult to implement a fine metal mask having a thickness of 10 µm or less by the top-down method, there has been an attempt to use a method in which a thin Invar alloy foil is manufactured through an electroforming method and then etched, or in which a fine metal mask with a pattern formed thereon is directly manufactured through an electroforming method.

On the other hand, since the Invar alloy is composed of an iron-nickel alloy, it is difficult to implement physical properties required for a metal mask if the uniformity of an alloy composition is not maintained in a plating solution. Accordingly, there has been so much research and development conducted for maintaining the uniformity of an alloy composition, but to date, an Invar alloy foil manufactured by an electroforming technique has not met physical properties required for a fine metal mask.

In addition, an organic component such as saccharin or thiourea is added to an Invar electrolyte solution to increase the density or control internal stress of a plated Invar alloy foil, and the organic component may be co-deposited into a crystal during a plating process, or may also be precipitated in the form of FeS or the like at a crystal boundary (in particular, near a triple point) during a heat-treatment process. The co-deposition of impurities as described above causes adverse effects such as increasing the thermal expansion coefficient of a manufactured Invar alloy foil and increasing brittleness. Accordingly, in order to improve the properties of an Invar alloy foil manufactured through continuous plating, there is a need for an electrolyte solution management technique for reducing factors which cause a thermal expansion coefficient, but there are few techniques developed in this regard.

### DISCLOSURE OF THE INVENTION

### TECHNICAL PROBLEM

An object of the present invention is to provide a metal foil continuous plating apparatus capable of manufacturing, with high quality, a metal foil such as a nickel foil and a copper foil, as well as an alloy foil such as a Fe-Ni alloy foil.

Another object of the present invention is to provide a metal foil continuous plating method capable of manufacturing, with high quality, a metal foil such as a nickel foil and a copper foil, as well as an alloy foil such as a Fe-Ni alloy foil.

Yet another object of the present invention is to provide a method for managing an electrolyte solution, the method capable of maintaining physical properties of a metal foil, which is formed during continuous plating, to be uniform, and minimizing factors adversely affecting the physical properties.

### TECHNICAL SOLUTION

An aspect of the present invention provides a metal foil continuous plating apparatus including an electrolytic bath for accommodating an electrolyte solution, a positive electrode arranged inside the electrolytic bath, a negative electrode arranged at a predetermined interval from the positive electrode so as to face the positive electrode, and a power supply device for applying a current to the positive electrode and the negative electrode, wherein the electrolyte solution is supplied to one side of a space formed between the positive electrode and the negative electrode, and the electrolyte solution is discharged from the other side of the space, wherein the height of the one side to which the electrolyte solution is supplied is formed higher than that of the other side so that the electrolyte solution flows through the space formed between the positive electrode and the negative electrode by means of a difference in potential energy between the one side and the other side, and passes through the space formed between the positive electrode and the negative electrode, during which metal ions contained in the electrolyte solution are electro-deposited on the negative electrode, thereby forming a metal foil.

Another aspect of the present invention provides a metal foil continuous plating method, which is a method for supplying an electrolyte solution between a positive electrode, and a negative electrode arranged at a predetermined interval from the positive electrode so as to face the positive electrode, and applying a current to the positive electrode and the negative electrode, thereby forming a metal foil on the surface of the negative electrode, wherein the height of one side of a space formed between the positive electrode and the negative electrode is formed higher than the height of the other side thereof, so that the electrolyte solution flows through the space formed between the positive electrode and the negative electrode by means of a difference in potential energy between the one side and the other side, and passes through the space formed between the positive electrode and the negative electrode.

Yet another aspect of the present invention provides a method for managing an electrolyte solution, the method including collecting an electrolyte solution from a plating bath or an electrolyte solution storage bath which supplies an electrolyte solution, selectively diluting the electrolyte solution at a predetermined ratio with a dilution solution, thereby adjusting the concentration of the electrolyte solution to an undiluted state or a diluted state at a predetermined ratio, irradiating, with light, the electrolyte solution with the adjusted concentration to analyze light-absorbing properties of the electrolyte solution with the adjusted the concentration, thereby analyzing the composition of the electrolyte solution, and based on a difference between the analyzed composition of the electrolyte solution and a preset composition of the electrolyte solution, adjusting the composition of the electrolyte solution of the plating bath, wherein if the light-absorbing properties analysis is performed with respect to an ultraviolet region, the analysis is performed in a state in which the electrolyte solution is diluted at a predetermined ratio with the dilution solution.

### ADVANTAGEOUS EFFECTS

According to the present invention, by using a difference in potential energy caused by a difference in height between a side to which an electrolyte solution is supplied and a side from which the electrolyte solution is discharged, the electrolyte solution is supplied by being controlled to pass through between a positive electrode and a negative electrode, so that both an amount of the electrolyte solution supplied between the positive electrode and the negative electrode and an amount of the electrolyte solution discharged is implemented to be in a steady-state or in a state very close to the steady state, which may significantly improve the uniformity of the composition of the electrolyte solution in contact with the negative electrode during electro-deposition compared to the prior art.

Accordingly, it is expected that a Fe-Ni alloy foil manufactured by the apparatus of the present invention to meet properties required of a fine metal mask.

In addition, if the apparatus or the method according to the present invention is used to manufacture a pure metal foil such as a nickel foil and a copper foil, the density of a formed foil is further improved, so that it is possible to obtain a metal foil having improved properties compared to those of a metal foil manufactured using a typical plating apparatus.

### BRIEF DESCRIPTION OF THE DRAWINGS

FIG. 1 is a perspective view of a metal foil continuous plating apparatus according to an embodiment of the present invention.
FIG. 2 is a partial exploded perspective view of the metal foil continuous plating apparatus according to an embodiment of the present invention.
FIG. 3 is a cross-sectional view of the metal foil continuous plating apparatus according to an embodiment of the present invention.
FIG. 4 is a cross-sectional view of a metal foil continuous plating apparatus according to another embodiment of the present invention.
FIG. 5 is a schematic view of a metal foil continuous plating apparatus according to yet another embodiment of the present invention.
FIG. 6 is a schematic view of a metal foil continuous plating apparatus according to still another embodiment of the present invention.
FIG. 7 shows results of ultraviolet-visible spectra measured while diluting an iron-nickel electrolyte solution with ultra-pure water.
FIG. 8A shows results of ultraviolet-visible spectra measured while diluting 97 g/L of a NiSO₄ solution with ultra-pure water, and FIG. 8B shows results of ultraviolet-visible spectra measured while diluting 85 g/L of a FeSO₄ solution with ultra-pure water.
FIG. 9A shows results of ultraviolet-visible spectra measured after exposing 85 g/L of a FeSO₄ solution to air for 24 hours and then diluting the solution with ultra-pure water, and FIG. 9B shows results of ultraviolet-visible spectra measured after exposing a 85 g/L FeSO₄ solution to air for 24 hours, removing a precipitate, and then diluting the solution with ultra-pure water.
FIG. 10A shows results of ultraviolet-visible spectra measured while diluting 2 g/L of an ascorbic acid solution with ultra-pure water, and FIG. 10B shows results of ultraviolet-visible spectra measured while diluting 2.6 g/L of a saccharin solution with ultra-pure water.
FIG. 11 shows ultraviolet-visible spectra of a standard plating solution (97 g/L of Ni, 85 g/L of FeSO₄, 2.6 g/L of saccharin, 1.0 g/L of ascorbic acid, 25 g/L of boric acid, and 0.2 g/L of lauryl) analyzed using a short optical path cell (transmission length: 0.1 mm), and ultraviolet-visible spectra of the plating solution analyzed using a general cell (transmission length: 10 mm) after diluting the plating solution to 1/100.
FIG. 12 shows results of ultraviolet-visible spectra of 30 g/L of NaCl, 0.2 g/L of sodium lauryl sulfate (hereinafter, referred to as 'lauryl'), and 25 g/L of boric acid.
FIG. 13A shows results of ultraviolet-visible spectra of a case in which NiSO₄ and various additives are mixed, and FIG. 13B shows results of ultraviolet-visible spectra of a case in which FeSO₄ and various additives are mixed.
FIG. 14A shows results of ultraviolet-visible spectra obtained by adding a predetermined amount of Fe³⁺ to 1.0 g/L of ascorbic acid and diluting the mixture to 1/200 in ultra-pure water, and FIG. 14B shows results of ultraviolet-visible spectra obtained by adding a predetermined amount of Fe³⁺ to 1.0 g/L of ascorbic acid and in an undiluted state.
FIG. 15 is a schematic view of a plating solution analyses process according to an embodiment of the present invention.
FIG. 16 shows a training set and a validation set for a partial least squares analysis algorithm.
FIG. 17 shows results of ultraviolet-visible spectra obtained through each solution shown in FIG. 16, wherein the solution was diluted to 1/200 in a 200 to 500 nm region, and in an undiluted sate in a 500 nm to 1000 nm region.
FIG. 18 shows calibration results derived from partial least square analysis using the data of FIG. 16 and FIG. 17.

### BEST MODE FOR CARRYING OUT THE INVENTION

Hereinafter, the configuration and operation of an embodiment of the present invention will be described with reference to the accompanying drawings.

In describing the present invention, detailed descriptions of related known functions or configurations will be omitted when it is determined that the detailed descriptions may unnecessarily obscure the gist of the present invention. In addition, when a portion is said to "include" any component, it means that the portion may further include other components rather than excluding the other components unless otherwise stated.

In the present invention, the "stead-state" refers to a state in which an amount of an electrolyte solution flowing into a space between a positive electrode and a negative electrode is the same as an amount of the electrolyte solution discharged from the space between the positive electrode and the negative electrode.

### [First embodiment]

A first embodiment of the present invention is a metal foil continuous plating apparatus including an electrolytic bath for accommodating an electrolyte solution, a positive electrode arranged inside the electrolytic bath, a negative electrode arranged at a predetermined interval from the positive electrode so as to face the positive electrode, and a power supply device for applying a current to the positive electrode and the negative electrode, wherein the electrolyte solution is supplied to one side of a space formed between the positive electrode and the negative electrode, and the electrolyte solution is discharged from the other side of the space, wherein the height of the one side to which the electrolyte solution is supplied is formed higher than that of the other side so that the electrolyte solution flows through the space formed between the positive electrode and the negative electrode by means of a difference in potential energy between the one side and the other side, and passes through the space formed between the positive electrode and the negative electrode, during which metal ions contained in the electrolyte solution are electro-deposited on the negative electrode, thereby forming a metal foil.

As described above, if an electrolyte solution is allowed to flow by means of a difference in potential energy between a place to which the electrolyte solution is supplied and a place from which the same is discharged, it is advantageous for the electrolyte solution to remain in a steady-state or in a state very close to the steady state within a space between a positive electrode and a negative electrode, thereby maintaining the composition of the electrolyte solution to be uniform between the positive electrode and the negative electrode at which electro-deposition occurs, and also, reducing the generation of bubbles or eddies in the process of flowing the electrolyte solution, so that a metal foil with excellent uniformity may be obtained. Accordingly, in the case of alloy plating, the uniformity of the composition may be increased across the entire metal foil, and in the case of single metal plating, the density may be increased.

A difference Hᵢₙ-Hₒᵤₜ between an electrolyte solution level Hᵢₙ on an electrolyte solution supply side and an electrolyte solution level Hₒᵤₜ of an electrolyte solution discharge side is not particularly limited as long as the electrolyte solution can flow by position energy. For example, the difference Hᵢₙ-Hₒᵤₜ may be greater than 0, or may be set to a value greater than or equal to an interval between the positive and negative electrodes. In addition, the difference Hᵢₙ-Hₒᵤₜ may be variously adjusted according to a flow rate required for the electrolyte solution. For example, If the flow rate is increased, the height difference may be increased, and if the flow rate is decreased, the height difference may be decreased.

In the first embodiment, an electrolyte solution guiding means may be further included, which is arranged on the electrolyte solution supply side of the positive electrode and guides the electrolyte solution to be supplied at a predetermined angle and rate to a space formed between the positive electrode and the negative electrode.

The electrolyte solution guiding means assists the electrolyte solution to enter at a predetermined angle and rate between the positive electrode and the negative electrode while maintaining a laminar flow, which may be advantageous in implementing the electrolyte solution supplied between the positive electrode and the negative electrode to be in a steady-state or in a state very close to the steady-state.

In the first embodiment, an electrolyte solution storage bath may be further included, which recovers the electrolyte solution discharged through the space formed between the positive electrode and the negative electrode, and processes the recovered electrolyte solution. The processing of the electrolyte solution includes removing impurities generated during an electro-deposition process, or adding necessary components for the electrolyte solution to maintain a composition in the initial state.

In the first embodiment, the electrolyte solution supplied through the electrolyte solution storage bath may be supplied to a lower portion of one side of the electrolyte solution guiding means, and rise to an upper portion of the electrolyte solution guiding means, thereby being supplied to the space between the positive electrode and the negative electrode.

In the first embodiment, as the electrolyte solution, various electrolyte solutions for forming metal foils, such as an electrolyte solution for forming an Fe-nickel alloy foil, an electrolyte solution for forming a nickel foil, and an electrolyte solution for forming a copper foil may be used. For example, the electrolyte solution for forming a Fe-Ni alloy foil may be iron sulfate (FeSO₄.7H₂O), nickel sulfate hexahydrate (NiSO₄.6H₂O), a boric acid (H₃BO₃), sodium saccharine (C₇H₄NO₃SNa), sodium lauryl sulfate (C1₂H₂₅O₄SNa), and sodium chloride (NaCl). More specifically, the electrolyte solution may include, based on 1 part by weight of iron sulfate, 0.49 to 0.94 parts by weight of nickel sulfate hexahydrate, 0.20 to 0.31 parts by weight of boric acid, 0.009 to 0.044 parts by weight of sodium saccharin, 0.0009 to 0.0033 parts by weight of sodium lauryl sulfate, and 0.23 to 0.37 parts by weight of sodium chloride.

In the first embodiment, the positive electrode may be formed in a plate shape having a downwardly concave arc shape, and as the positive electrode material, any material may be used without a particular limitation as long as it has properties of being able to be used as a positive electrode. In addition, the shape of the positive electrode may be various adjusted in accordance with the shape of the negative electrode arranged to face the positive electrode.

In the first embodiment, the negative electrode may be formed in a drum shape having a circular cross-section.

In the first embodiment, the drum-shaped negative electrode is composed of a clad metal having two or more layers, wherein the surface layer may be composed of a first metal, such as titanium, a titanium alloy, or stainless steel, and the inner layer may be composed of copper (Cu), silver (Ag), aluminum (Al), or an alloy thereof (a copper alloy, a silver alloy, or an aluminum alloy) having excellent electrical conductivity. The clad metal may be manufactured by various methods, such as welding two thin-plates, joining the same with a bonding material, plating, or coating.

In the first embodiment, on the surface of the negative electrode, irregularities (or patterns) may be formed to form surface roughness of a metal foil which is formed on the negative electrode in a range of predetermined values.

In the first embodiment, the electrolyte solution guiding means may have a flat shape inclined at a predetermined angle or may be curved, and through the adjustment of the shape (inclined or curved) of the electrolyte solution guiding means, the entry angle of the electrolyte solution supplied to the space formed between the positive electrode and the negative electrode may be adjusted.

In the first embodiment, an auxiliary guide (cover) to level the height of the electrolyte solution may be arranged on an upper side of the electrolyte solution guiding means.

The height of the electrolyte solution may be maintained constant with respect to the entire drum-type negative electrode by means of the auxiliary guide (cover).

The entry angle of the electrolyte solution may be variously adjusted, for example, to be substantially the same as the curvature of the positive electrode and the negative electrode.

In the first embodiment, the shape of the place from which the electrolyte solution is discharged may be a shape which allows the electrolyte solution to be directly discharged to an electrolyte solution storage bath after passing through between the positive electrode and the positive electrode facing each other, or discharged to the electrolyte solution storage bath after passing thought a discharge guide in a flat shape, a concave shape, a convex shape, or the like.

In the first embodiment, the electrolyte solution may be equipped with a means to suppress the occurrence of a vortex current in order to suppress the generation of bubbles during the process in which the electrolyte solution is discharged to the electrolyte solution storage bath.

In the first embodiment, the surface of the negative electrode may have a predetermined pattern composed of a region in which electro-deposition occurs and a region in which the electro-deposition does not occur. The pattern of the negative electrode is transferred to a metal foil formed through the negative electrode with the pattern, so that the metal foil may be immediately molded into a shape of such as a metal mesh or a fine metal mask.

### [Second embodiment]

A second embodiment of the present invention is a metal foil continuous plating method, which is a method for supplying an electrolyte solution between a positive electrode, and a negative electrode arranged at a predetermined interval from the positive electrode so as to face the positive electrode, and applying a current to the positive electrode and the negative electrode, thereby forming a metal foil on the surface of the negative electrode, wherein the height of one side of a space formed between the positive electrode and the negative electrode is formed higher than the height of the other side thereof, so that the electrolyte solution flows through the space formed between the positive electrode and the negative electrode by means of a difference in potential energy between the one side and the other side, and passes through the space formed between the positive electrode and the negative electrode, during which a metal foil is on the surface of the negative electrode.

### [Third embodiment]

A third embodiment of the present invention is a method for managing an electrolyte solution, the method including collecting an electrolyte solution from a plating bath or an electrolyte solution storage bath which supplies an electrolyte solution, selectively diluting the electrolyte solution at a predetermined ratio with a dilution solution, thereby adjusting the concentration of the electrolyte solution to an undiluted state or a diluted state at a predetermined ratio, irradiating, with light, the electrolyte solution with the adjusted concentration to analyze light-absorbing properties of the electrolyte solution with the adjusted the concentration, thereby analyzing the composition of the electrolyte solution, and based on a difference between the analyzed composition of the electrolyte solution and a preset composition of the electrolyte solution, adjusting the composition of the electrolyte solution of the plating bath, wherein if the light-absorbing properties analysis is performed with respect to an ultraviolet region, the analysis is performed in a state in which the electrolyte solution is diluted at a predetermined ratio with the dilution solution.

In the electrolyte solution analysis method of the present invention, in performing composition analysis on an electrolyte solution, the analysis is not performed on the electrolyte solution in an undiluted state, but performed on the electrolyte solution in a state diluted at a predetermined ratio with a dilution solution, so that the analysis accuracy is increased.

In the third embodiment, the dilution solution preferably contains water (H₂O), has no light absorption in a wavelength range of 200 nm to 500 nm, and the has a dilution ratio of 1/2 to 1/400 between the electrolyte solution and the dilution solution. Here, absence of absorption in the wavelength region of 200 nm to 500 nm means not only that absorption has not been completely achieved, but also that absorption has achieved at a noise level that does not affect the analysis.

This is because if the dilution ratio of the electrolyte solution is less than 1/2, or greater than 1/400, it is difficult to increase the accuracy of absorption property analysis of a component detected in the ultraviolet region. Here, the dilution ratio of 1/2 means mixing a dilution solution corresponding to twice the volume of an electrolyte solution, and 1/400 means mixing a dilution solution corresponding to 400 times the volume of an electrolyte solution. More preferably, the dilution ratio of the electrolyte solution may be 1/50 to 1/200.

In the third embodiment, when performing the absorption property analysis, if a wavelength region of 300 nm to 1000 nm is analyzed, the analysis may be performed on the electrolyte solution in an undiluted state without being diluted.

This is because if a visible light region or a wavelength region of 300 nm to 1000 nm, which is close to the visible light region is analyzed, it is possible to increase the analysis accuracy when the analysis is performed on the electrolyte solution in an undiluted state rather than in a diluted state.

In the third embodiment, the spectroscopic analysis may include first spectroscopic analysis for performing analysis with respect to a wavelength range of 10 nm to 500 nm, and second spectroscopic analysis for performing analysis with respect to a wavelength range of 300 nm to 1000 nm.

Through the ultraviolet-visible spectroscopy, it is possible to analyze the composition of various components included in an iron-nickel electrolyte solution.

In the third embodiment, the electrolyte solution main contain Fe²⁺, Ni²⁺, and saccharin.

In the third embodiment, the electrolyte solution composition analysis may include processing data, which has been obtained by the absorption properties analysis, with a multi-variable calibration.

Through multi-variable calibration, it is possible to quickly analyze, with high reliability, various metal ions and organic components included in the iron-nickel electrolyte solution, particularly.

The multi-variable calibration may be performed through, for example, a partial least square (PLS) algorithm.

Through the partial least square (PLS) algorithm, it is possible to obtain highly reliable analysis results for the composition of various components included in the iron-nickel electrolyte solution.

In the third embodiment, the partial least square algorithm may be optimized to analyze Ni²⁺, Fe²⁺, Fe³⁺, a stress-reliever, an antioxidant, or an iron-ion precipitate, which may be included in the iron-nickel electrolyte solution, but the present invention is not limited to the components illustrated above.

In the third embodiment, the stress reliever may include saccharin, and the antioxidant may include ascorbic acid, but the present invention is not limited to the analysis of an electrolyte solution including the stress reliever or the antioxidant illustrated above.

In the third embodiment, the wavelength of the light may be 10 nm to 1000 nm.

Through above, it is possible to perform analysis on an ultraviolet-visible-near-infrared region, so that it is possible to perform analysis on various components included in the electrolyte solution.

### <Example 1>

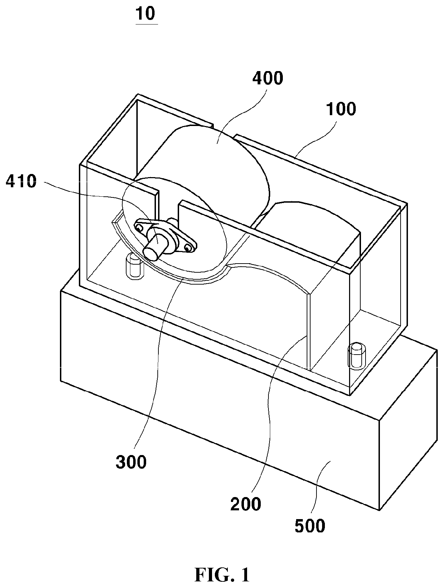

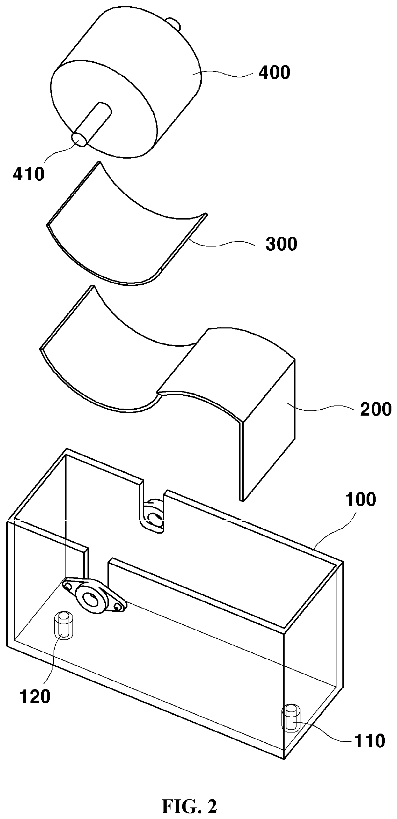

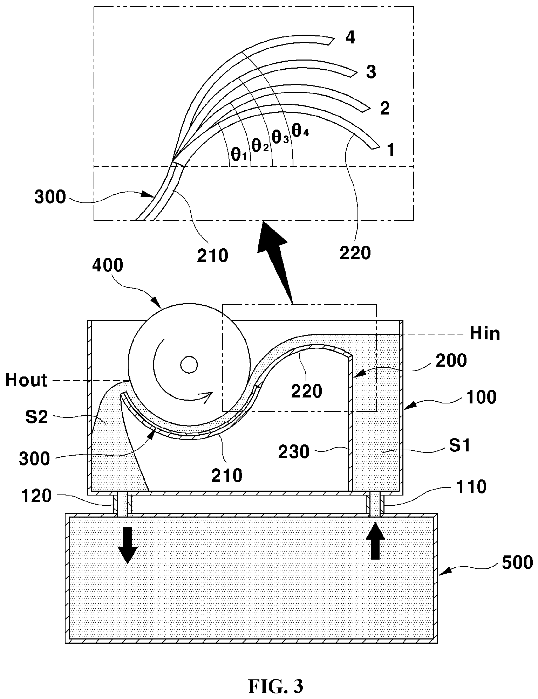

FIG. 1 is a perspective view of a metal foil continuous plating apparatus according to Example 1 of the present invention, FIG. 2 is a partial exploded perspective view of the metal foil continuous plating apparatus according to Example 1 of the present invention, and FIG. 3 is a cross-sectional view of the metal foil continuous plating apparatus according to Example 1 of the present invention.

Referring to FIG. 1 to FIG. 3, the metal foil continuous plating apparatus according to Example 1 of the present invention includes a plating bath 100, an electrolyte solution guiding means 200 arranged inside the plating bath 100, a positive electrode 300 coupled to one side of an upper surface of the electrolyte solution guiding means 200, a negative electrode 400 arranged at a predetermined interval from the positive electrode 300, and an electrolyte solution storage bath 500 arranged in a lower portion of the plating bath 100.

The plating bath 100 is composed of a container forming a space therein, and in the embodiment of the present invention, the container is not equipped with a cover for covering an upper portion thereof, but may be equipped with a cover for covering the upper portion. In addition, the space is formed in a substantially rectangular shape, but is not limited to the shape, and the space may be formed in various shapes such as a rectangular shape, a circular shape, and an oval shape.

As illustrated in FIG. 2, the electrolyte solution guiding means 200 is formed by including a positive electrode attachment part 210 which is downwardly concave and to which a positive electrode is attached, and an electrolyte solution guiding part 220 which guides the electrolyte solution supplied from the electrolyte solution storage bath 500 to enter, at a controlled angle and rate, a space between the positive electrode 300 and the negative electrode 400.

The positive electrode attachment part 210 is formed to be downwardly concave to correspond to the shape of the positive electrode.

The electrolyte solution guiding part 220 has a gentle upwardly convex shape. In the embodiment of the present invention, the electrolyte solution guiding part 220 is formed in a gentle convex shape, but may be formed in various shapes such as an inclined plane shape. In addition, as shown in an upper portion of FIG. 3, the angle at which the electrolyte solution guiding part 220 affects the entry angle and rate of the electrolyte solution, and for the installation, may be adjusted to various angles (θ1, θ2, θ3, θ4, and the like) according to plating conditions.

A left end portion of the positive electrode attachment portion 210 in the drawing is formed open to allow the electrolyte solution, which has passed between the positive electrode and the negative electrode, to be directly discharged downward.

The maximum height of the electrolyte solution guiding part 220 is the height of a position to which the electrolyte solution is supplied, and is formed to be higher than the height of a position from which the electrolyte solution is discharged. Accordingly, there is a difference in potential energy between of a position at which the electrolyte solution is supplied to the electrolyte guiding part 220 and a position from which the electrolyte solution is discharged, so that the electrolyte solution is supplied to an upper portion of the electrolyte solution guiding part 220, the electrolyte solution may flow to the position from which the electrolyte solution is discharged by self-weight without a force applied from the outside.

In addition, the electrolyte solution guiding means 200 forms a partition wall 230 for separating a space to which the electrolyte solution is supplied (first space) and a space from which the electrolyte solution is discharged (second space) inside the plating bath 100, so that the supplied electrolyte solution and the discharged electrolyte solution are not mixed with each other.

An electrolyte solution dropped from the position from which the electrolyte solution is discharged is recovered to the electrolyte solution storage bath 500 through an inlet 510 of the electrolyte solution storage bath 500 in the second space, and an electrolyte solution discharged through an outlet 520 is supplied to the first space.

The positive electrode 300 may be formed in a plate shape having a cross-section that is approximately in the shape of an arc, but is not necessarily limited to the plate shape, and is not particularly limited as long as the positive electrode has an opposing surface that maintains a predetermined interval from the negative electrode 400.

For example, the positive electrode 300 itself may be in a shape of being supported inside the plating bath 100 without being attached to the electrolyte solution guiding means 200.

The negative electrode 400 is formed in a roll shape extending by a predetermined length in a length direction for continuous plating. The negative electrode 400 is formed on a rotating shaft 410 and is rotatavely driven by a driving means (not shown).

The negative electrode may be formed of a material clad with copper and titanium having excellent electrical conductivity, and the cladding material is preferable for forming a uniform current density across the entire negative electrode by rapidly transferring a current applied from the outside to the entire negative electrode through copper.

It may be preferable that the interval between the positive electrode 300 and the negative electrode 400 is maintained to be the same interval throughout to allow the electrolyte solution to maintain a steady-state. According to a need to control the composition of the electrolyte solution or to control the composition of a formed foil, the interval between the positive electrode 300 and the negative electrode 400 may gradually be increased or decreased from the supply side of the electrolyte solution toward the discharge side thereof.

The electrolyte solution storage bath 500 is positioned in a lower portion of the plating bath 100 to recover an electrolyte solution on which an electro-deposition process has been performed through an electrolyte solution recovery port 120 connected to a second space S2 of the plating bath 100, and supplies a processed electrolyte solution to a first space S1 through an electrolyte solution supply port 110 connected to the first space S1 of the plating bath100.

Meanwhile, in Example 1 of the present invention, the electrolyte solution storage bath 500 is installed in the lower portion of the plating bath 100, but may be installed at various positions, such as being installed in parallel with the plating bath 100, or installed in an upper portion of the plating bath 100.

In addition, instead of processing the electrolyte solution through the electrolyte solution storage bath 500 and supplying the processed electrolyte solution to the plating bath 100, an electrolyte solution recovery bath and an electrolyte solution supply bath may be separately used. In this case, an electrolyte solution recovered in the electrolyte solution recovery bath may be subjected to processing processes, such as impurity removal, composition control, and the like, and then supplied to the electrolyte solution supply bath.

Using the metal foil continuous plating apparatus 10 as described above, a metal foil may be manufactured as follows.

Referring to FIG. 3, an electrolyte solution stored in the electrolyte solution storage bath 500 is supplied to a lower part of the first space S1 through the electrolyte solution supply port 110. As the electrolyte solution is supplied, the electrolyte solution fills up the first space S1, and when the level of the electrolyte solution is higher than an upper end of the electrolyte solution guiding part 220, the electrolyte solution flows down into a space between the positive electrode 300 and the negative electrode 400 by self-weight, and the flowing electrolyte solution passes through the space between the positive electrode 300 and the negative electrode 400 and is discharged to the second space S2.

Then, when an amount of the electrolyte solution supplied to the space between the positive electrode 300 and the negative electrode 400 and an amount of the electrolyte solution discharged reach a steady-state or a state very close to the steady-state, the negative electrode 400 is rotatavely driven and applied with power to allow electro-deposition to occur on the negative electrode 400. Of course, the negative electrode 400 may be rotatably driven simultaneously with the supply of the electrolyte solution, or before the steady-state is reached.

### <Example 2>

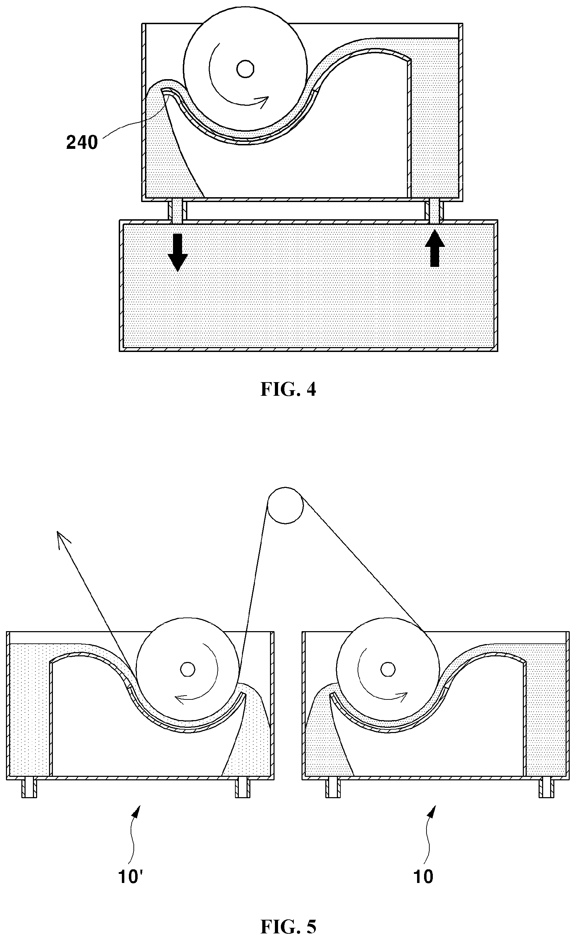

FIG. 4 is a cross-sectional view of a metal foil continuous plating apparatus according to another embodiment of the present invention.

The metal foil continuous plating apparatus according to Example 2 differs from the metal foil continuous plating apparatus according to Example 1 in that the electrolyte solution discharge guiding part 240 extending in a curved manner to the outside of the negative electrode is formed on the side of an electrolyte solution discharge part in the same manner as the side of an electrolyte solution supply part, thereby allowing the electrolyte solution to be discharged is smoothly discharged, and thus, has a structure advantageous in maintaining a lamina flow (or steady-state) on the discharge side.

### <Example 3>

FIG. 5 is a schematic view of a metal foil continuous plating apparatus according to yet another embodiment of the present invention.

The metal foil continuous plating apparatus according to Example 3 is an example of an apparatus which performing plating by arranging the metal foil continuous plating apparatus according to Example 1 in parallel. In Example 3, two of the metal foil continuous plating apparatuses are arranged, but if necessary, three or more of the apparatuses may be arranged and used.

The metal foil continuous plating apparatus according to Example 3 shows a process in which an electro-deposited foil is peeled off from the first metal foil continuous plating apparatus 10 and then introduced into a second metal foil continuous plating apparatus 10' to allow electro-deposition in two layers continuously.

The metal foil continuous plating apparatus according to Example 3 uses a method for performing plating through the second metal foil continuous plating apparatus 10' if a metal foil formed in the first metal foil continuous plating apparatus 10 is thin, additional plating is partially required, or plating of different types of metals is required. In the case in which additional plating is partially required, the surface of a negative electrode forming the second metal foil continuous plating apparatus 10' may be divided into a region in which electro-deposition occurs and a region in which the electro-deposition does not occur.

In addition, since the first metal foil continuous plating apparatus 10 and the second metal foil continuous plating apparatus 10' have separate plating baths, it is possible to use different compositions of an electrolyte solution to be used, in which case, it is also possible to manufacture metal foils having different compositions in a thickness direction.

### <Example 4>

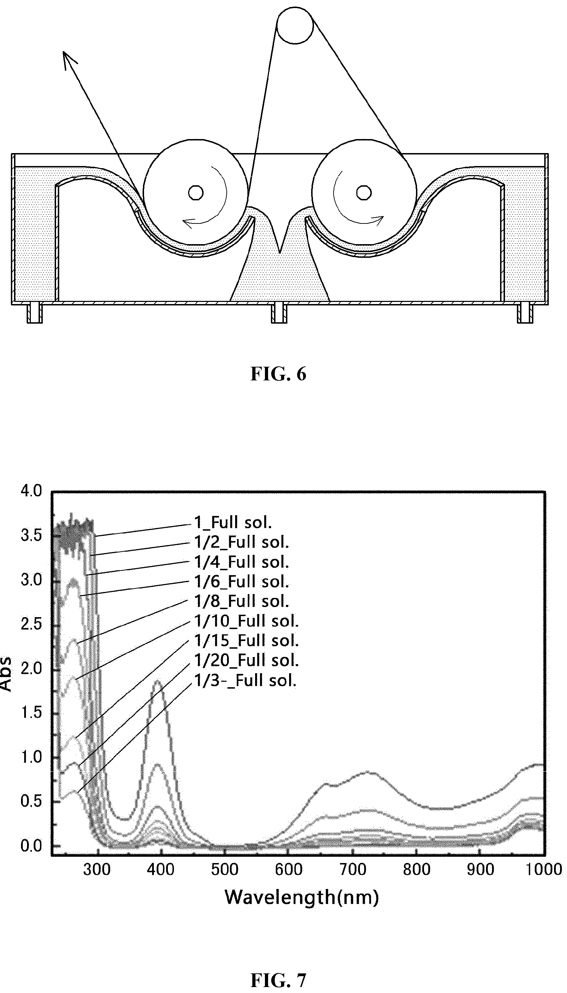

FIG. 6 is a schematic view of a metal foil continuous plating apparatus according to still another embodiment of the present invention.

The metal foil continuous plating apparatus according to Example 4 differs from the metal foil continuous plating apparatus according to Example 3 in that two of the metal foil continuous plating apparatuses are arranged in one plating bath, and if necessary, three or more of the metal foil continuous plating apparatuses may be arranged in one plating bath.

### <Example 5>

Example 5 relates to a method for managing an electrolyte solution used in the above-described metal foil continuous plating apparatus.

Spectrum analysis was performed on a Fe-Ni electrolyte solution with a light source in a wavelength of 200 nm 1000 nm. At this time, ultraviolet-visible analysis was performed in a scan mode at room temperature, and the scanning rate was 10 nm/s.

Referring to FIG. 7, peaks for light absorption were observed between 200 nm to 300 nm, around 400 nm, around 650 nm, around 725 nm, and around 1000 nm. Among the above, the absorption peak observed between 200 nm to 300 nm was observed in a form beyond a detection limit, but it can be confirmed that the peak changes into a normal peak form as the dilution ratio of the electrolyte solution increases.

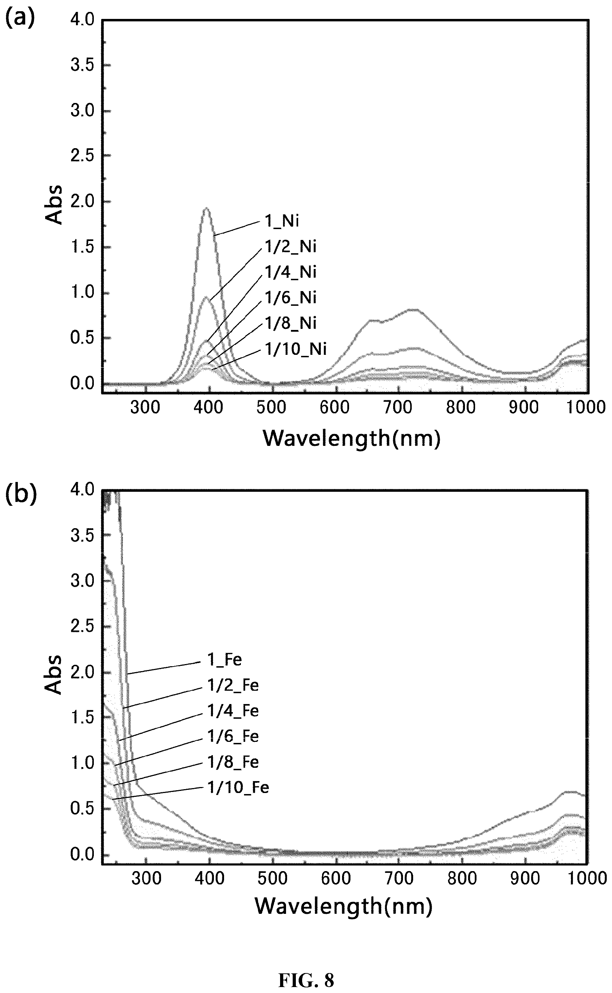

Referring to FIG. 8A, characteristic peaks of Ni²⁺ ions were observed around 400 nm, around 650 nm, around 725 nm, and around 1000 nm. Referring to FIG. 8B, characteristic peaks of Fe²⁺ ions were observed around 900 nm. A peak observed between 200 nm to 300 nm in FIG. 8A appears to be a characteristic peak of Fe³⁺contained as an impurity in FeSO₄.

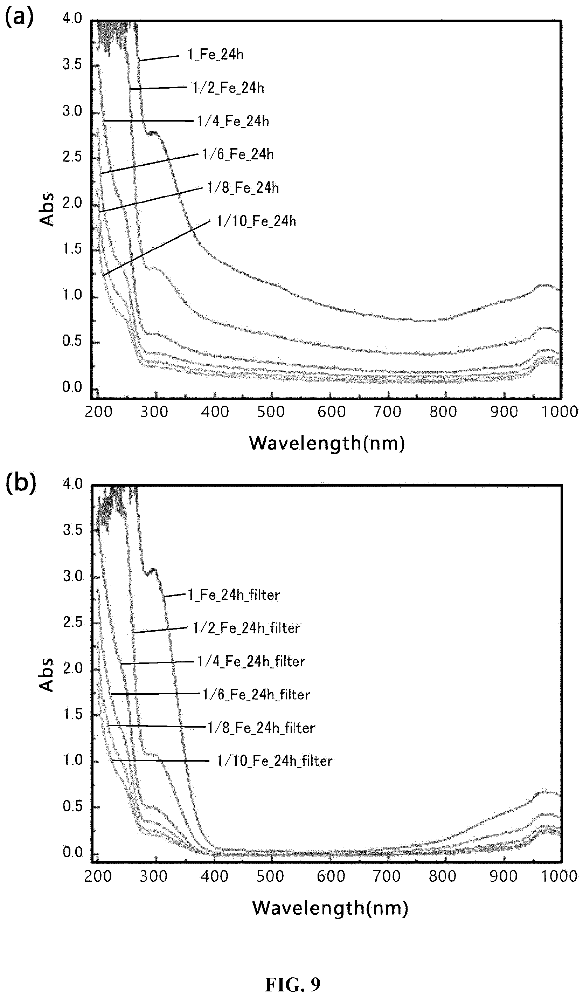

Referring to FIG. 9A, peaks of Fe²⁺ ions change with exposure time in the air, which seems to be due to oxidation of the Fe²⁺ ions to Fe³⁺ and the formation of precipitates. Referring to the spectra of FIG. 9B before and after the removal of the precipitates, a characteristic peak for Fe³⁺ was observed around 325 nm, and the absorption by the precipitates was widely observed in 200 nm to 1000 nm.

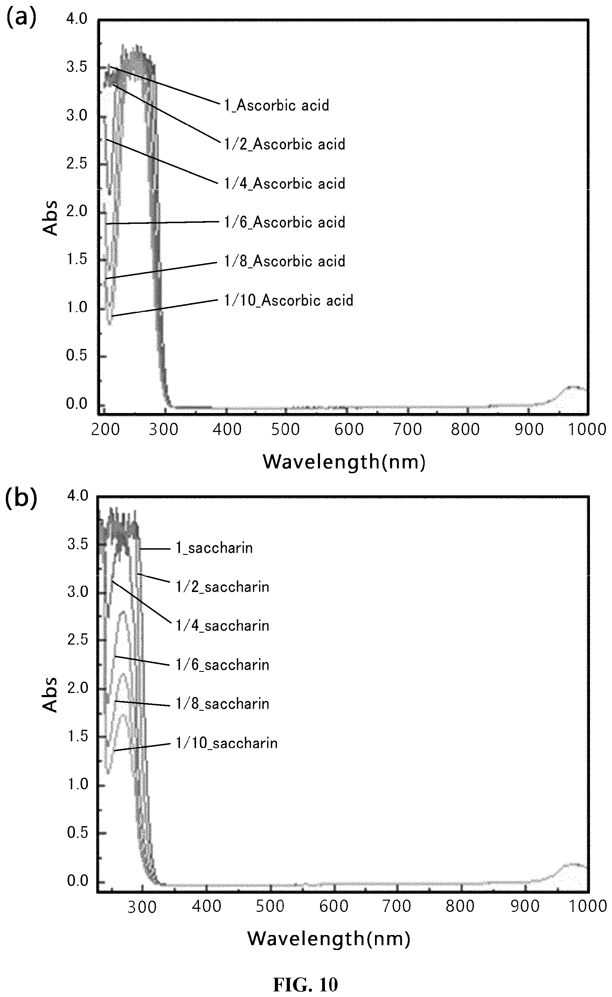

Referring to FIG. 10A and FIG. 10B, absorption was observed in a region of 200 nm to 300 nm when saccharin and ascorbic acid were included. At this time, the intensity of the absorption was strong, so that a peak in a noise form was observed beyond the detection limit when the analysis was performed in an undiluted state. However, when the solution containing saccharin and ascorbic acid was diluted to 1/10, a normal peak form was observed, and characteristic peaks were respectively observed in a region of 200 nm to 300 nm for the saccharin and around 270 nm for the ascorbic acid.

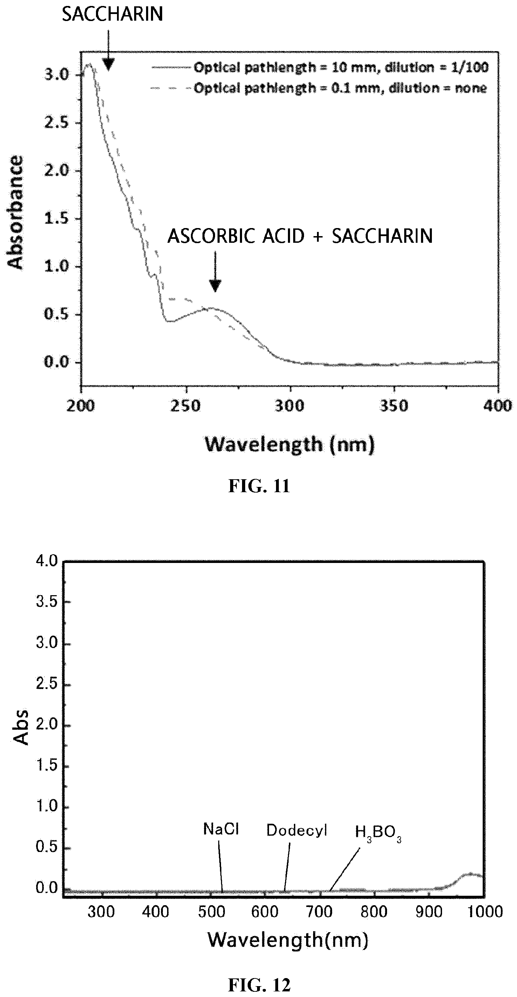

FIG. 11 shows ultraviolet-visible spectra of a standard plating solution (97 g/L of Ni, 85 g/L of FeSO4, 2.6 g/L of saccharin, 1.0 g/L of ascorbic acid, 25 g/L of boric acid, and 0.2 g/L of lauryl) analyzed using a short optical path cell (transmission length: 0.1 mm). Ultraviolet-visible spectra results of the plating solution analyzed using a general cell (transmission length: 10 mm) after diluting the plating solution to 1/100 were also illustrated. In both cases in which the short optical path cell was used and in which the plating solution was diluted, peaks of saccharin and ascorbic acid were observed in the ultraviolet region. In both cases, the peak size and the shape of saccharin were similar, but the peak size and position of ascorbic acid were different from each other. From the above, it can be seen that performing the analysis by diluting the plating solution is advantageous in terms of component analysis since it is possible to obtain peaks with higher sensitivity compared to the case of using the short optical path cell.

In addition, when performing the analysis by dilution, it is also possible to mitigate a matrix effect. In general, when a plating solution is used, a side reaction such as a hydrogen generation reaction occurs, so that a change in pH occurs. Therefore, in order to analyze a material such as ascorbic acid, which exhibits pH dependence, it is required to adjust the pH of a solution prior to the analysis, but when the analysis is performed by dilution, an accurate analysis result may be obtained without the pH adjustment process.

Referring to FIG. 12, in the case of electrolyte solutions containing NaCl, boric acid, and lauryl, no characteristic peak was observed in a 200 nm to 1000 nm region.

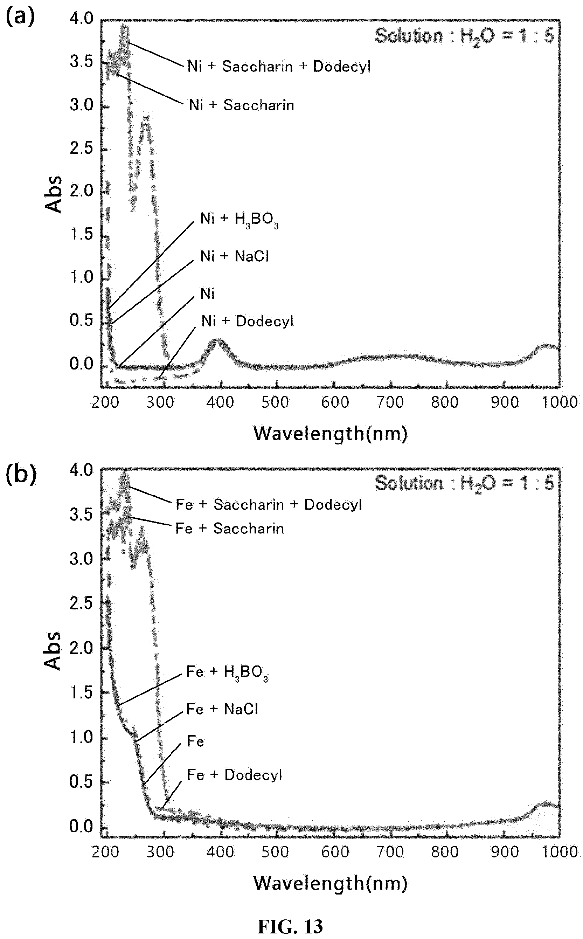

FIG. 13A shows ultraviolet-visible spectra analyzed by adding NaCl, boric acid, lauryl, and the like to a solution containing 97 g/L of NiSO₄. As shown in FIG. 13A, a characteristic peak for NiSO₄ was clearly observed, but no characteristic peak changes were observed according to the addition of NaCl, boric acid, lauryl, and the like. This means that Ni²⁺ ions do not interact with NaCl, boric acid, lauryl, and the like in the solution.

FIG. 13B shows ultraviolet-visible spectra analyzed by adding NaCl, boric acid, lauryl, and the like to a solution containing 85 g/L of FeSO₄. As in the case of FIG. 13A, a characteristic peak for FeSO₄ was clearly observed, but no characteristic peak changes were observed according to the addition of NaCl, boric acid, lauryl, and the like. This means that Fe²⁺ ions also have no interaction with NaCl, boric acid, lauryl, and the like.

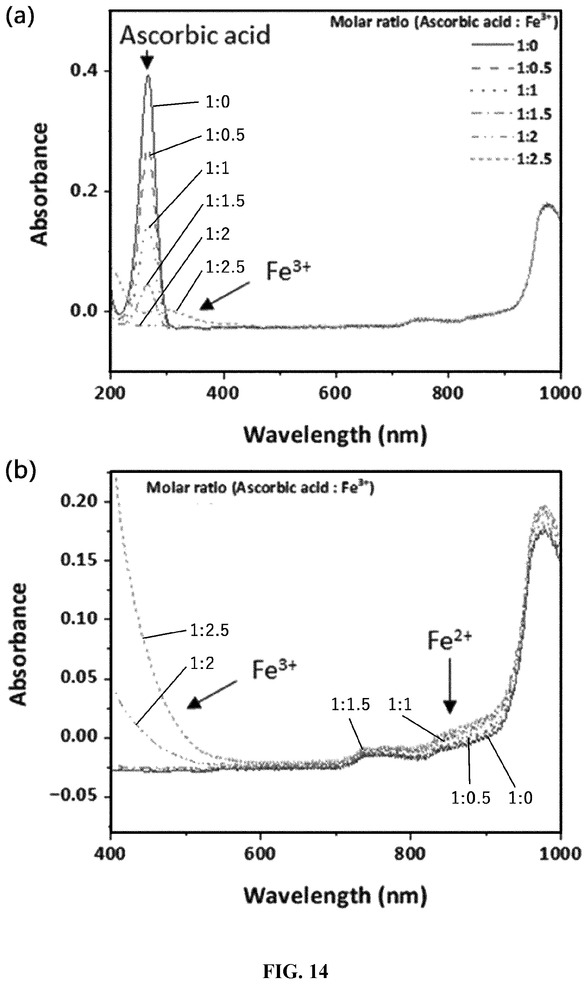

FIG. 14 shows results of ultraviolet-visible spectra obtained by adding Fe³⁺ to a solution containing ascorbic acid. A peak of the ascorbic acid observed around 270 nm gradually decreased with the addition of Fe³⁺. No additional absorption by Fe³⁺ was observed, and an elevation in a peak presumed to be Fe²⁺ was observed. When the molecular ratio of ascorbic acid and Fe³⁺ reached 1:2, the peaks of ascorbic acid disappeared altogether, peaks caused by Fe³⁺ began to be observed, and when the ratio reached 1:2.5, the peaks of Fe³⁺ became clear. This shows that ascorbic acid and Fe³⁺ reacted in a ratio of 1:2, resulting in oxidizing the ascorbic acid and reducing the Fe³⁺ to Fe²⁺.

Through the analysis results of the absorption properties of the solutions as described above, it can be seen that Ni²⁺, Fe²⁺, Fe³⁺, the Fe precipitate, saccharin, and ascorbic acid, which are included in the electrolyte solution, exhibited absorption properties in the analysis of the wavelength of 200 nm to 1000 nm, but NaCl, boric acid, lauryl, and the like did not exhibit absorption properties, and also had substantially no interaction with Ni²⁺ and Fe²⁺ ions.

In addition, Ni²⁺, Fe²⁺, Fe³⁺, the Fe precipitate, and the like have distinct absorption properties in the visible light (partially including near-infrared rays) region of 300 nm to 1000 nm, and organic substances such as saccharin and ascorbic acid have distinct absorption properties in the ultraviolet range of 200 to 300 nm, wherein characteristic peaks are clearly observed in a diluted state at a predetermined ratio (e.g., 1/200).

Fe³⁺ reacted rapidly with ascorbic acid and was reduced to Fe²⁺, and the reaction ratio was ascorbic acid:Fe³⁺ = 1:2.

Hydrogen ions did not have a separate peak, but changes in pH may change the intensity of the ascorbic acid peak. At this time, when the analysis was performed by dilution, the intensity of the ascorbic acid peak was greater than that of the case in which the short optical path cell was used.

From the above, it can be seen that when analyzing an iron-nickel electrolyte solution, it is preferable to perform the analysis in an undiluted state in the visible light range and in a diluted state in the ultraviolet range, so it is preferable to perform the analysis on both the solution in an undiluted state and the solution in a diluted state during ultraviolet-visible analysis.

In addition, since the peaks from each substance overlap, it can be seen that it is preferable to use a multi-variable analysis algorithm when performing the analysis. Chemical species affecting the spectra were Fe²⁺, Fe³⁺, Ni²⁺, saccharin, ascorbic acid, hydrogen ions, precipitates, and the like, and among these species, Fe²⁺, Fe³⁺, Ni²⁺, saccharin, and ascorbic acid were able to be calibrated with high accuracy.

Next, multi-variable calibration through a partial least square (PLS) algorithm was performed to analyze five materials (Fe²⁺, Fe³⁺, Ni²⁺, ascorbic acid, and saccharin) having absorption properties.

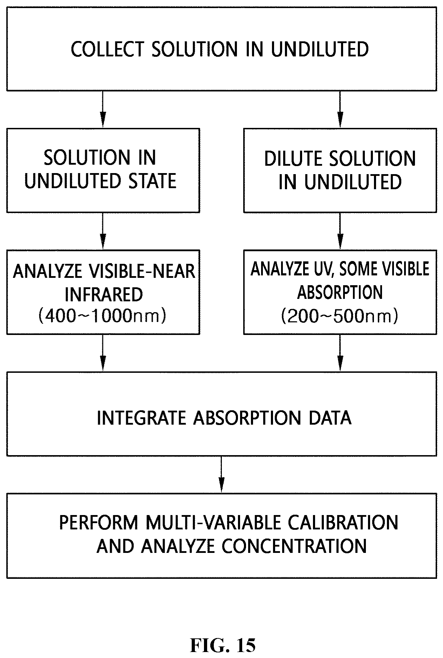

FIG. 15 shows a process of collecting data for the partial least square analysis. A plating solution in an undiluted state was collected for the analysis, and some of the solution was diluted to 1/200 in ultra-pure water. Absorbance in a wavelength range of 200 nm to 500 nm with respect to the diluted plating solution was analyzed, and absorbance in a wavelength range of 500 nm to 1000 nm with respect to the plating solution in an undiluted state was analyzed, which were integrated to form a single spectrum. Multi-variable calibration was performed using the partial least square method between initial plating solution components and the above spectrum, and the accuracy thereof was evaluated.

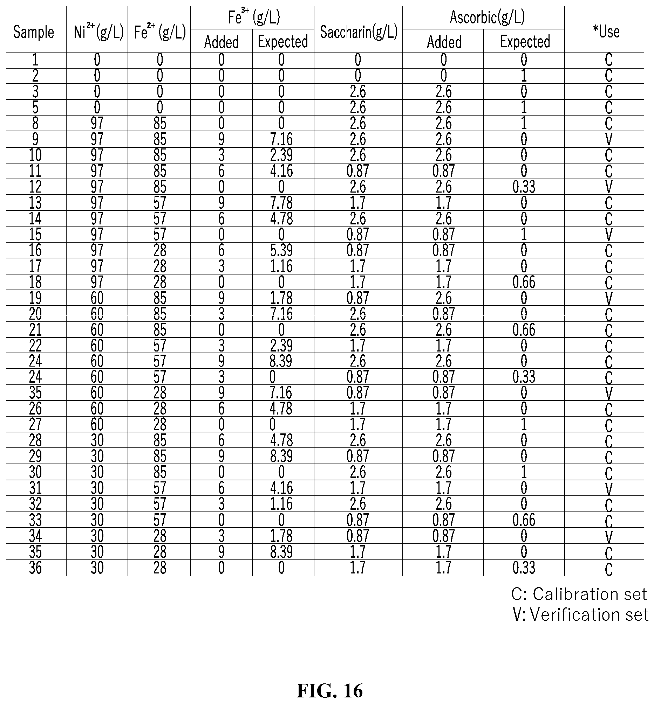

FIG. 16 shows a training set and a validation set for a partial least square analysis algorithm. In the training set and the validation set, the concentration of Fe³⁺ and ascorbic acid were adjusted in concentration of the reaction between the two materials.

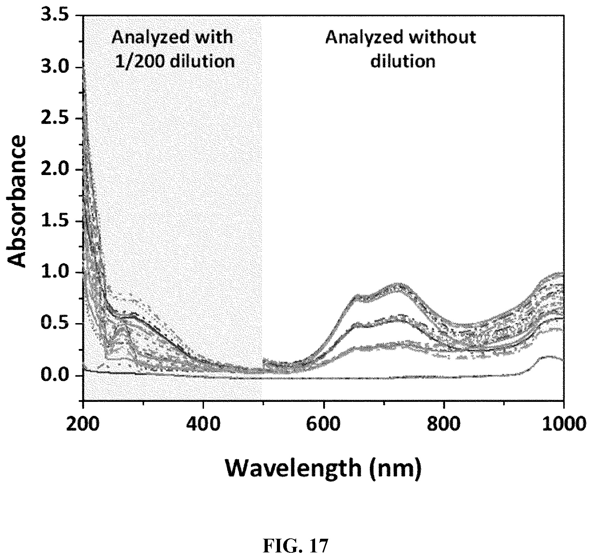

As shown in FIG. 17, ultraviolet-visible spectrum analysis was performed for each training set, and the spectrum of the electrolyte solution diluted to 1/200 was connected for the ultraviolet region, and the spectrum of the electrolyte solution in an undiluted state was connected for the visible region to determine as an x-axis factor.

The analysis was performed using the R software, and used a built-in PLS algorithm. A cross-validation method was used for verification, and no separate data preprocessing was performed.

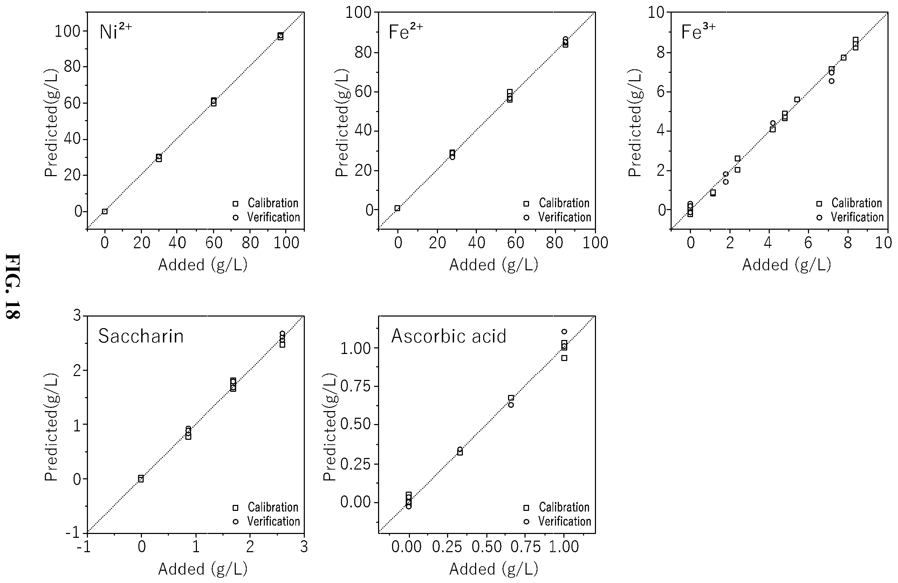

After training, a linear variable (LV) value at which a linear coefficient is minimized was determined, and analysis results of the training set and the validation set measured in the corresponding LV are shown in FIG. 18. As can be confirmed in FIG. 18, high accuracy can be confirmed through the fact that the determined value is very close to the actual concentration.

### [Description of the Reference Numerals or Symbols]

10: Metal foil continuous plating apparatus
100: Plating bath
200: Electrolyte guiding means
300: Positive electrode
400: Negative electrode
500: Electrolyte solution storage bath

## Claims

1. A metal foil continuous plating apparatus comprising:
an electrolytic bath for accommodating an electrolyte solution;
a positive electrode arranged inside the electrolytic bath;
a negative electrode arranged at a predetermined interval from the positive electrode so as to face the positive electrode; and
a power device for applying a current to the positive electrode and the negative electrode,
wherein the electrolyte solution is supplied to one side of a space formed between the positive electrode and the negative electrode, and the electrolyte solution is discharged from the other side of the space, wherein the height of the one side to which the electrolyte solution is supplied is formed higher than the height of the other side so that the electrolyte solution flows through the space formed between the positive electrode and the negative electrode by means of a difference in potential energy between the one side and the other side, and which the electrolyte solution is passing through the space formed between the positive electrode and the negative electrode, metal ions contained in the electrolyte solution are electro-deposited on the negative electrode, thereby forming a metal foil.

2. The metal foil continuous plating apparatus of claim 1, further comprising an electrolyte solution guiding means arranged to be in contact with the positive electrode, and guiding the electrolyte solution to be supplied at a predetermined angle and rate to the space formed between the positive electrode and the negative electrode.

3. The metal foil continuous plating apparatus of claim 1, further comprising an electrolyte solution storage bath for recovering the electrolyte solution discharged through the space formed between the positive electrode and the negative electrode, and processing the recovered electrolyte solution.

4. The metal foil continuous plating apparatus of claim 1, wherein the electrolyte solution supplied through the electrolyte solution storage bath is supplied to a lower portion of one side of the electrolyte solution guiding means, and rises to an upper portion of the electrolyte solution guiding means, thereby being supplied to the space between the positive electrode and the negative electrode.

5. The metal foil continuous plating apparatus of claim 1, wherein the electrolyte solution is an electrolyte solution for forming an iron-nickel alloy foil, an electrolyte solution for forming a nickel foil, or an electrolyte solution for forming a copper foil.

6. The metal foil continuous plating apparatus of claim 1, wherein:
the positive electrode is formed in a plate shape having a downwardly concave arc shape; and
the negative electrode is formed in a drum shape having a circular cross-section.

7. The metal foil continuous plating apparatus of claim 1, wherein the electrolyte solution guiding means has a flat shape inclined at a predetermined angle, or a convex shape with a predetermined curvature, and through the electrolyte solution guiding means, the entry angle of the electrolyte solution supplied to the space formed between the positive electrode and the negative electrode is adjusted.

8. The metal foil continuous plating apparatus of claim 1, further comprising, on an upper side of the electrolyte solution guiding means, an auxiliary guide for leveling the water surface level of the electrolyte solution.

9. A metal foil continuous plating apparatus comprising a first metal foil continuous plating apparatus and a second metal foil continuous plating apparatus set forth in claim 1, wherein a first metal foil manufactured by the first metal foil continuous plating apparatus is introduced into the second metal foil continuous plating apparatus to performing plating on the first metal foil through the second metal foil continuous plating apparatus, thereby forming a second metal foil.

10. A method for manufacturing a metal foil, the method being a method for supplying an electrolyte solution between a positive electrode, and a negative electrode arranged at a predetermined interval from the positive electrode so as to face the positive electrode, and applying a current to the positive electrode and the negative electrode, thereby forming a metal foil on the surface of the negative electrode, wherein the height of one side of a space formed between the positive electrode and the negative electrode is formed higher than the height of the other side thereof, so that the electrolyte solution flows through the space formed between the positive electrode and the negative electrode by means of a difference in potential energy between the one side and the other side, and passes through the space formed between the positive electrode and the negative electrode, during which a metal foil is formed on the surface of the negative electrode.

11. A method for managing an electrolyte solution, the method comprising:
collecting an electrolyte solution from a plating bath or an electrolyte solution storage bath which supplies an electrolyte solution;
selectively diluting the electrolyte solution at a predetermined ratio with a dilution solution, thereby adjusting the concentration of the electrolyte solution to an undiluted state or a diluted state at a predetermined ratio;
irradiating, with light, the electrolyte solution with the adjusted concentration to analyze light-absorbing properties of the electrolyte solution with the adjusted the concentration, thereby analyzing the composition of the electrolyte solution; and
based on a difference between the analyzed composition of the electrolyte solution and a preset composition of the electrolyte solution, adjusting the composition of the electrolyte solution of the plating bath,
wherein if the light-absorbing properties analysis is performed with respect to an ultraviolet region, the analysis is performed in a state in which the electrolyte solution is diluted at a predetermined ratio with the dilution solution.

12. The method of claim 11, wherein the dilution solution contains water (H₂O), has no absorption in a wavelength range of 200 nm to 500 nm, and is diluted at a volume ratio of 2 times to 400 times with respect to the electrolyte solution.

13. The method of claim 11, wherein in the light-absorbing properties analysis, if the analysis is performed with respect to a wavelength range of 300 nm to 1000 nm, the analysis is performed in a state in which the electrolyte solution is an undiluted state without being diluted.

14. The method of claim 11, wherein the light-absorbing properties analysis comprises:
first spectroscopic analysis for performing analysis with respect to a wavelength range of 10 nm to 500 nm; and
second spectroscopic analysis for performing analysis with respect to a wavelength range of 300 nm to 1000 nm.

15. The method of claim 11, wherein the electrolyte solution composition analysis comprises processing data, which has been obtained by the light-absorbing properties analysis, with a multi-variable calibration.

16. The method of claim 11, wherein the electrolyte solution contains Fe²⁺, Ni²⁺, and saccharin.

17. The method of claim 16, wherein the electrolyte solution further contains an antioxidant.
